# EUROPEAN PATENT APPLICATION

(11) **EP 4 683 480 A1**
(43) Date of publication of application: **21.01.2026**
(21) Application number: 25190112.0
(22) Date of filing: 17.07.2025
(51) Int. Cl.: H10K 59/80

(54) **DISPLAY DEVICE AND ELECTRONIC DEVICE INCLUDING THE SAME**

(30) Priority: 19.07.2024 KR 20240095891
(71) Applicant: Samsung Display Co., Ltd., Yongin-si, Gyeonggi-do 17113 (KR)
(72) Inventor: KIM, Hyun, 17113 Yongin-si (KR); LEE, Seungmin, 17113 Yongin-si (KR)
(74) Representative: Marks & Clerk LLP

(57) **Abstract**

A display device including a display area and a peripheral area includes a first substrate including a first surface, a display layer disposed on the first surface of the first substrate and including a pixel circuit layer and a display element layer disposed on the pixel circuit layer, a second substrate including a second surface opposite the first surface and disposed on the first substrate to be spaced apart from the display layer, a sealing member supporting the second substrate from the first substrate in the peripheral area, a filling member filled between the first substrate and the second substrate, a first structure fixed to the first surface in the peripheral area, and a second structure fixed to the second surface in the peripheral area and in contact with the first structure.

## Description

### BACKGROUND

### 1. Field

Embodiments relate to a device, and more particularly, to a display device.

### 2. Description of the Related Art

Mobility-based electronic devices are being widely used. Recently, tablet personal computers in addition to relatively small electronic devices, such as mobile phones, are being widely used as mobile electronic devices.

In order to support various functions, these mobile electronic devices include a display device to provide visual information such as an image or a video to a user. Recently, as the sizes of other components for driving a display device are being decreased, an area of the display device in an electronic device is being gradually increased, and a structure that may be bent by a certain angle from a flat state is being developed.

### SUMMARY

Embodiments include a display device in which stress acting on a sealing member is dispersed and penetration of external foreign substances into the sealing member is reduced.

However, these objectives are illustrative, and problems to be solved by the disclosure are not limited thereto.

Additional features will be set forth in part in the description which follows and, in part, will be apparent from the description, or may be learned by practice of the presented embodiments of the disclosure.

In an embodiment of the disclosure, a display device in which a display area and a peripheral area are defined includes a first substrate including a first surface, a display layer disposed on the first surface of the first substrate and including a pixel circuit layer and a display element layer disposed on the pixel circuit layer, a second substrate including a second surface opposite the first surface and disposed on the first substrate to be spaced apart from the display layer, a sealing member supporting the second substrate from the first substrate in the peripheral area, a filling member filled between the first substrate and the second substrate, a first structure fixed to the first surface in the peripheral area, and a second structure fixed to the second surface in the peripheral area and in contact with the first structure.

In an embodiment, the first structure may include a first-1 structure extending from the first surface in a first-1 direction to the second surface, and a first-2 structure extending from the first-1 structure in a second-1 direction intersecting the first-1 direction, where the second structure includes a second-1 structure extending from the second surface in a first-2 direction opposite to the first-1 direction, and a second-2 structure extending from the second-1 structure in a second-2 direction opposite to the second-1 direction.

In an embodiment, the first-2 structure and the second-2 structure may contact each other.

In an embodiment, in a cross section of the first substrate, the first structure and the second structure may each have an 'L' shape.

In an embodiment, the first-2 structure may be closer to the second substrate than the second-2 structure is to the second substrate.

In an embodiment, the second-2 structure may be closer to the first substrate than the first-2 structure is to the first substrate.

In an embodiment, the second-1 structure may be closer to the display layer than the first-1 structure is to the display layer.

In an embodiment, the first structure and the second structure may be in surface contact with each other.

In an embodiment, at least one of the first structure and the second structure may be sealed by the sealing member.

In an embodiment, at least one of the first structure and the second structure may include an inorganic material.

In an embodiment of the disclosure, an electronic device includes a display device in which a display area and a peripheral area are defined and which includes a first part, a second part disposed on the first part, a sealing member supporting the second part from the first part in the peripheral area, and a filling member filled between the first part and the second part, where the first part includes a first substrate, a display layer disposed on the first substrate, and a first structure fixed to the first substrate in the peripheral area, where the second part includes a second substrate and a second structure fixed to the second substrate in the peripheral area, where the first structure and the second structure are fastened to each other.

In an embodiment, the first structure and the second structure may be in surface contact with each other.

In an embodiment, in a cross section of the first substrate, the first structure and the second structure may each have an 'L' shape.

In an embodiment, at least one of the first structure and the second structure may be sealed by the sealing member.

In an embodiment, at least one of the first structure and the second structure may include an inorganic material.

In an embodiment, the first structure may include a first-1 structure extending from the first substrate in a first-1 direction to the second substrate, and a first-2 structure extending from the first-1 structure in a second-1 direction intersecting the first-1 direction, where the second structure includes a second-1 structure extending from the second substrate in a first-2 direction opposite to the first-1 direction; and a second-2 structure extending from the second-1 structure in a second-2 direction opposite to the second-1 direction.

In an embodiment, the first-2 structure and the second-2 structure may contact each other.

In an embodiment, the first-2 structure may be closer to the second substrate than the second-2 structure is to the second substrate.

In an embodiment, the second-2 structure may be closer to the first substrate than the first-2 structure is to the first substrate.

In an embodiment, the second-1 structure may be closer to the display layer than the first-1 structure is to the display layer.

At least some of the above and other features of the invention are set out in the claims.

Other features and advantages other than the above description will be clear from the details of the drawings, the claims and the details of the disclosure.

### BRIEF DESCRIPTION OF THE DRAWINGS

The above and other features and advantages of illustrative embodiments of the disclosure will be more apparent from the following description taken in conjunction with the accompanying drawings, in which:
FIG. 1 is a perspective view schematically illustrating an embodiment of a portion of a display device;
FIGS. 2 and 3 are cross-sectional views schematically illustrating an embodiment of a portion of a display device;
FIGS. 4 to 6 are cross-sectional views schematically illustrating an embodiment of a portion of a display device;
FIGS. 7 to 9 are cross-sectional views schematically illustrating an embodiment of a portion of a display device;
FIG. 10 is a plan view schematically illustrating an embodiment of a display device;
FIG. 11 illustrates an embodiment of a display element and a pixel circuit connected thereto in a pixel of a display device;
FIG. 12 is a cross-sectional view schematically illustrating an embodiment of a portion of a display device;
FIG. 13 is a block diagram illustrating an electronic device according to an embodiment; and
FIG. 14 is a view illustrating an embodiment of the electronic device of FIG. 13 implemented as a smartphone.

### DETAILED DESCRIPTION

Reference will now be made in detail to embodiments, illustrative embodiments of which are illustrated in the accompanying drawings, where like reference numerals refer to like elements throughout. In this regard, the illustrated embodiments may have different forms and should not be construed as being limited to the descriptions set forth herein. Accordingly, the embodiments are merely described below, by referring to the drawing figures, to explain features of the description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the description allows for various changes and numerous embodiments, illustrative embodiments will be illustrated in the drawings and described in detail in the written description. Effects and features of the disclosure, and methods of achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings. When describing embodiments with reference to the accompanying drawings, the same or corresponding elements are denoted by the same reference numerals and redundant descriptions thereof are omitted.

It will be understood that although the terms "first," "second" etc. may be used herein to describe various elements, these elements should not be limited by these terms. These terms are only used to distinguish one element from another.

The singular forms "a," "an," and "the" as used herein are intended to include the plural forms as well unless the context clearly indicates otherwise.

It will be further understood that the terms "include" and/or "comprise" used herein specify the presence of stated features or elements, but do not preclude the presence or addition of one or more other features or elements.

It will be further understood that, when a layer, region, or element is referred to as being "on" another layer, region, or element, it may be directly or indirectly on the other layer, region, or element. That is, for example, intervening layers, regions, or elements may be present.

Also, sizes of elements in the drawings may be exaggerated or reduced for convenience of explanation. For example, because sizes and thicknesses of elements in the drawings are arbitrarily illustrated for convenience of explanation, the disclosure is not limited thereto.

In the following embodiments, the x-axis, y-axis, and z-axis are not limited to the three axes in the Cartesian coordinate system, but may be interpreted in a broad sense including these. For example, the x-axis, the y-axis, and the z-axis may be perpendicular to one another or may represent different directions that are not perpendicular to one another.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

In cases where an embodiment may be implemented differently, a predetermined process sequence may be performed differently from the described sequence. In an embodiment, two processes described in succession may be performed substantially at the same time, or may be performed in an order opposite to that in which they are described, for example.

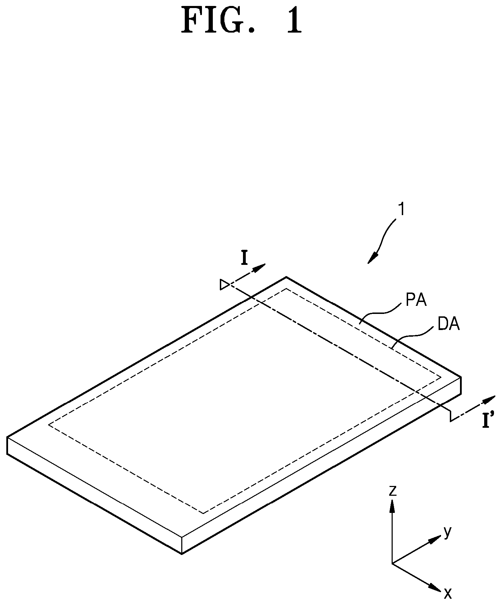

FIG. 1 is a perspective view schematically illustrating an embodiment of a portion of a display device 1.

Referring to FIG. 1, the display device 1 includes a display area DA and a peripheral area PA. The peripheral area PA may be outside the display area DA and may surround the display area DA. Various lines and driving circuits which transmit electric signals to the display area DA may be arranged in the peripheral area PA. The display device 1 may provide a predetermined image by light emitted from a plurality of pixels in the display area DA.

In embodiments, the display device 1 may include an organic light-emitting display, an inorganic light-emitting display, an inorganic electroluminescence display, or a quantum dot light-emitting display. Hereinafter, an organic light-emitting display will be described as an example. The display device 1 may be implemented in various types of electronic devices such as mobile phones, laptop computers, and smart watches.

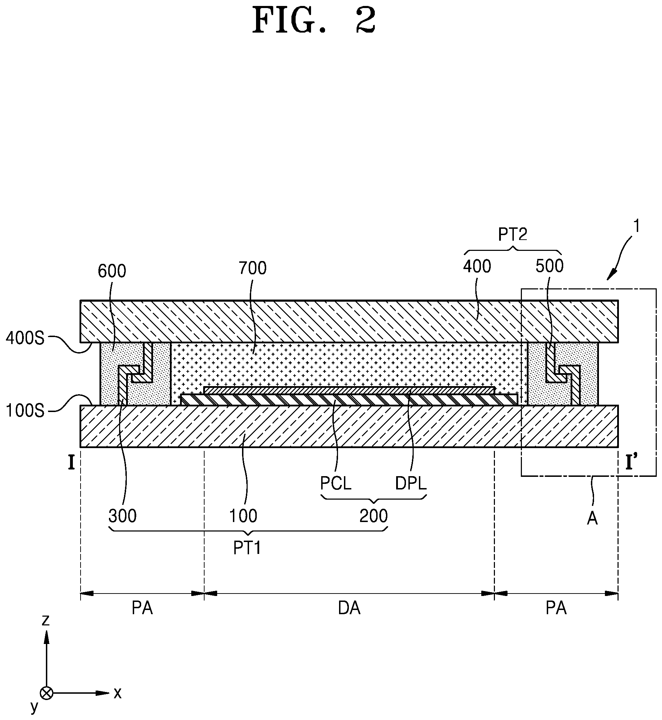

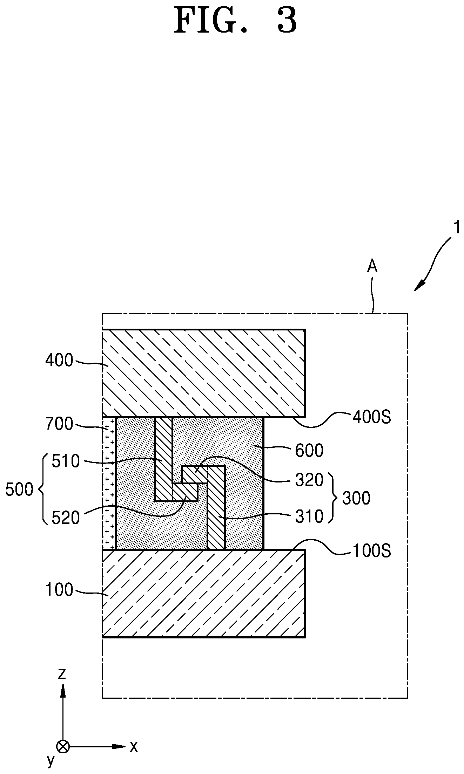

FIG. 2 and 3 are cross-sectional views schematically illustrating an embodiment of a portion of the display device 1.

Specifically, FIG. 2 is a cross-sectional view taken along line I-I' of FIG. 1, and FIG. 3 is an enlarged view of portion A of FIG. 2.

Referring to FIGS. 1 to 3, the display device 1 may include a first part PT1, a second part PT2, a sealing member 600, and a filling member 700.

The first part PT1 may include a first substrate 100, a display layer 200, and a first structure 300.

The first substrate 100 may include a glass material or a polymer resin. In an embodiment, the first substrate 100 may include a glass material including or consisting of SiO₂ as a main component or may include a resin such as reinforced plastic, for example.

A display layer 200 is disposed on the first substrate 100. The display layer 200 includes a pixel circuit layer PCL and a display element layer DPL disposed on the pixel circuit layer. The pixel circuit layer PCL may include a pixel circuit and insulating layers arranged for each of the plurality of pixels, and the display element layer DPL may include display elements arranged for each of the plurality of pixels. A plurality of insulating layers may be disposed between the pixel circuit and the display element. Some lines and insulating layers of the pixel circuit layer PCL may extend to the peripheral area PA.

The second part PT2 may be disposed on the first part PT1. The second part PT2 may include a second substrate 400 and a second structure 500.

The second substrate 400 is disposed on the first substrate 100 to be spaced apart from the display layer 200. The second substrate 400 may face the first substrate 100. The second substrate 400 may include a glass material or a polymer resin. In an embodiment, the second substrate 400 may include a glass material including or consisting of SiO₂ as a main component or may include a resin such as reinforced plastic, for example.

The sealing member 600 may support the second part PT2 from the first part PT1 in the peripheral area PA. That is, the sealing member 600 supports the second substrate 400 from the first substrate 100 in the peripheral area PA. The sealing member 600 may be disposed to surround the display area DA in the peripheral area PA. The sealing member 600 may include a sealant or a frit, and may be cured by heat and/or a laser to bond the first substrate 100 and the second substrate 400 to each other. The second substrate 400 may be bonded to the first substrate 100 by the sealing member 600. The second substrate 400 and the sealing member 600 may prevent infiltration of external moisture, air, or the like into the display layer 200 including the display elements.

The filling member 700 may be filled between the first part PT1 and the second part PT2. That is, the filling member 700 is filled between the first substrate 100 and the second substrate 400. The filling member 700 may be disposed between the first substrate 100 and the second substrate 400. The filling member 700 may be disposed between the display layer 200 and the second substrate 400. The filling member 700 may be surrounded by the sealing member 600. The filling member 700 may protect the display layer 200 from an impact that may be applied from the outside.

The filling member 700 may include a transparent insulating material. In some embodiments, the filling member 700 may include an organic sealant such as urethane resin, epoxy resin, or acrylic resin, or may include an inorganic sealant such as silicone. In embodiments, the urethane resin may include urethane acrylate. In embodiments, the acrylic resin may include butyl acrylate and ethylhexyl acrylate. In some embodiments, the filling member 700 may include polyimide.

A surface of the first substrate 100 facing the second substrate 400 is also referred to as a first surface 100S, and a surface of the second substrate 400 facing the first substrate 100 is also referred to as a second surface 400S. That is, the first substrate 100 includes the first surface 100S, and the second substrate 400 includes the second surface 400S opposite the first surface 100S. In this structure, the display layer 200, the sealing member 600, and the filling member 700 may be disposed on the first surface 100S. Additionally, the sealing member 600 and the filling member 700 may be disposed on the second surface 400S.

The first structure 300 is fixed to the first surface 100S in the peripheral area PA. The first structure 300 may include a first-1 structure 310 and a first-2 structure 320. The first-1 structure 310 may extend from the first surface 100S in a first-1 direction (e.g., +z-axis direction) to the second surface 400S. That is, the first-1 structure 310 may extend from the first substrate 100 in the first-1 direction (e.g., +z-axis direction) to the second substrate 400. The first-2 structure 320 may extend from the first-1 structure 310 in a second-1 direction (e.g., -x-axis direction) that intersects the first-1 direction (e.g., +z-axis direction). The first-1 structure 310 and the first-2 structure 320 may each have a longitudinal direction.

The second structure 500 may be fixed to the second surface 400S in the peripheral area PA. The second structure 500 may include a second-1 structure 510 and a second-2 structure 520. The second-1 structure 510 extends from the second surface 400S in the first-2 direction (e.g., -z-axis direction) opposite to the first-1 direction (e.g., +z-axis direction). That is, the second-1 structure 510 may extend from the second substrate 400 in the first-2 direction (e.g., -z-axis direction). The second-2 structure 520 may extend from the second-1 structure 510 in a second-2 direction (e.g., +x-axis direction) opposite to the second-1 direction (e.g., -x-axis direction). The second-1 structure 510 and the second-2 structure 520 may each be provided to have a longitudinal direction.

That is, in a cross section of the first substrate 100, the first structure 300 and the second structure 500 may each have an 'L' shape.

The second structure 500 may contact the first structure 300. The first structure 300 and the second structure 500 may be fastened to each other. In an embodiment, the first structure 300 and the second structure 500 may be in face-to-face contact with each other, for example. However, this is an illustrative embodiment, and the contact method of the first structure 300 and the second structure 500 is not limited to thereto. Specifically, the first-2 structure 320 and the second-2 structure 520 may contact each other.

The first-2 structure 320 may be closer to the second substrate 400 than the second-2 structure 520 is to the second substrate 400. Additionally, the second-2 structure 520 may be closer to the first substrate 100 than the first-2 structure 320 is to the first substrate 100. That is, the first-2 structure 320 may be disposed on the second-2 structure 520. The second-1 structure 510 may be closer to the display layer 200 than the first-1 structure 310 is to the display layer 200. That is, the first-1 structure 310 may be disposed outside the second-1 structure 510. In this structure, the first structure 300 may surround the second structure 500.

At least one of the first structure 300 and the second structure 500 may overlap the sealing member 600. At least one of the first structure 300 and the second structure 500 may be sealed by the sealing member 600. In an embodiment, each of the first structure 300 and the second structure 500 may be sealed by the sealing member 600, for example.

At least one of the first structure 300 and the second structure 500 may include an inorganic material. In an embodiment, the first structure 300 may include the same material as that of the first substrate 100, and the second structure 500 may include the same material as that of the second substrate 400, for example. At least one of the first structure 300 and the second structure 500 may include two or more inorganic materials. In an embodiment, at least one of the first structure 300 and the second structure 500 may include a SiNx material and a SiOx material, for example. In an alternative embodiment, at least one of the first structure 300 and the second structure 500 may include an inorganic material and an organic material. In an embodiment, at least one of the first structure 300 and the second structure 500 may include a metal material and a PI (polyimide) material, for example. However, this is an illustrative embodiment, and the materials included in the first structure 300 and the second structure 500 are not limited to thereto.

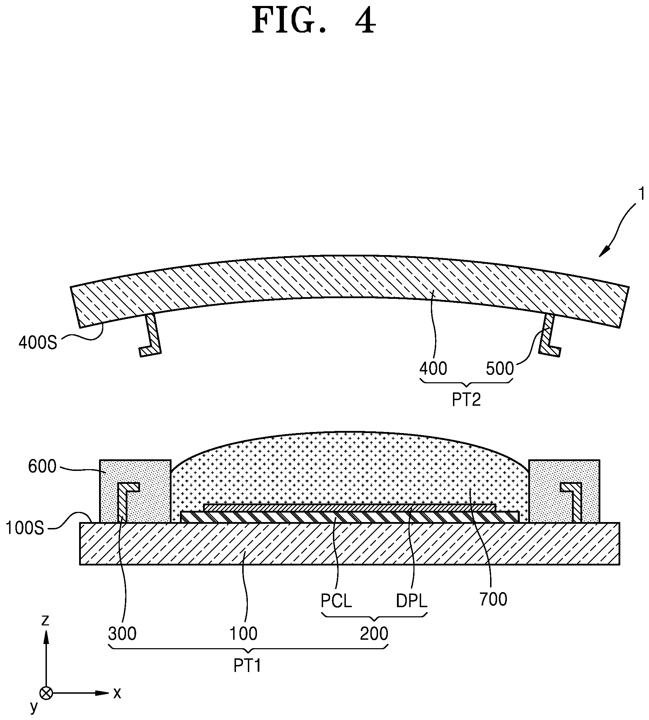

FIGS. 4 to 6 are cross-sectional views schematically illustrating an embodiment of a portion of the display device 1.

In FIGS. 4 to 6, the same reference numerals as those in FIGS. 1 to 3 refer to the same members, and their duplicate descriptions will be omitted.

Referring to FIGS. 4 to 6, the first part PT1 and the second part PT2 may be fixed by a sealing member 600 with a filling member 700 interposed therebetween.

Referring to FIG. 4, the first part PT1 may include the first substrate 100, the display layer 200, and the first structure 300. The display layer 200 is disposed on the first substrate 100. The display layer 200 includes a pixel circuit layer PCL and a display element layer DPL disposed on the pixel circuit layer. The first structure 300 is fixed to the first surface 100S.

The second part PT2 may include a second substrate 400 and a second structure 500. The second structure 500 is fixed to the second surface 400S. Before the second part PT2 is coupled to the first part PT1, the second substrate 400 may have a curvature. The second substrate 400 may be provided to be convex in a first-1 direction (e.g., +z-axis direction) away from the first substrate 100. The second substrate 400 may be provided to be concave in the first-2 direction (e.g., -z-axis direction) toward the first substrate 100. The second surface 400S of the second substrate 400 may be a concave surface.

As shown in FIG. 4, the sealing member 600 and the filling member 700 may be disposed on the first surface 100S of the first substrate 100. At this time, the filling member 700 may be provided to be convex in the first-1 direction (e.g., +z-axis direction) away from the first surface 100S.

Unlike shown in FIG. 4, the sealing member 600 and the filling member 700 may be disposed on the second surface 400S of the second substrate 400. At this time, the filling member 700 may be provided to be convex in the first-2 direction (e.g., -z-axis direction) away from the second surface 400S.

Hereinafter, for convenience of explanation, the description will be made on the assumption that the sealing member 600 and the filling member 700 are disposed on the first surface 100S of the first substrate 100.

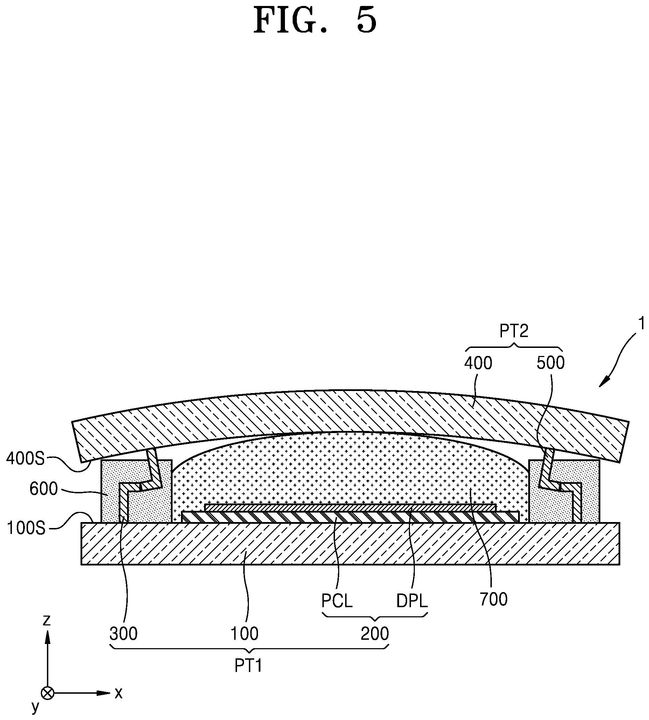

Referring to FIG. 5, the first part PT1 and the second part PT2 may be combined with each other. Because the second substrate 400 has a curvature, the first-2 structure (refer to 320 of FIG. 3) of the first structure 300 may not be affected by the second-2 structure (refer to 520 of FIG. 3) of the second structure 500. That is, before the first structure 300 and the second structure 500 are fastened, the first-2 structure (refer to 320 of FIG. 3) and the second-2 structure (refer to 520 of FIG. 3) may be spaced apart from each other.

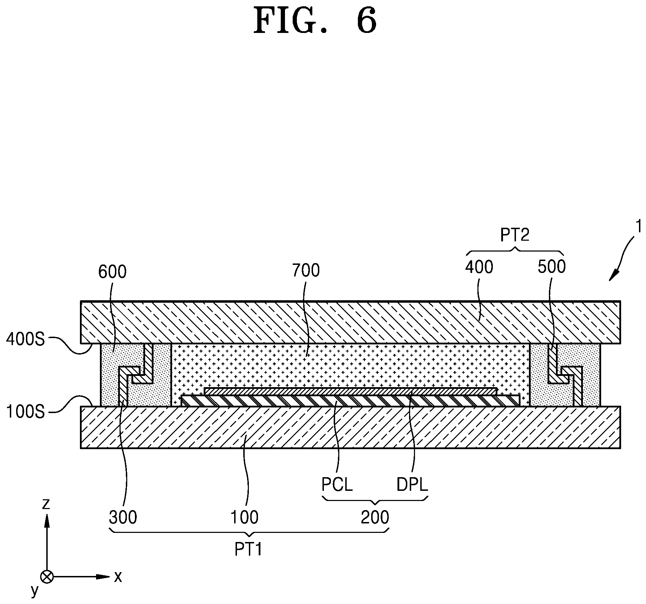

Referring to FIG. 6, the first part PT1 and the second part PT2 may be fixed to each other. As the first substrate 100, the second substrate 400, and the sealing member 600 contact each other, the filling member 700 spreads widely and the convex surface of the filling member 700 may become flat. That is, the filling member 700 may fill the space between the first substrate 100, the second substrate 400, and the sealing member 600.

Accordingly, as the curvature of the second substrate 400 gradually decreases, the first structure 300 and the second structure 500 may be fastened to each other. Finally, the curvature of the second substrate 400 may be 0. That is, the second surface 400S of the second substrate 400 may be flat. Accordingly, the first-2 structure (refer to 320 of FIG. 3) of the first structure 300 and the second-2 structure (refer to 520 of FIG. 3) of the second structure 500 may contact each other.

As the sealing member 600 is hardened by heat and/or a laser, the first substrate 100 and the second substrate 400 may be bonded to each other. The second substrate 400 may be bonded to the first substrate 100 by the sealing member 600.

According to the embodiment described with reference to FIGS. 2 to 6, as the first structure 300 and the second structure 500 are fastened to each other in the form of a latch, stress on the sealing member 600 caused by pressure between the first part PT1 and the second part PT2 by the filling member 700 may be reduced. In addition, a surface area between the first part PT1 and the sealing member 600 may be increased due to the first structure 300, and a surface area between the second part PT2 and the sealing member 600 may be increased due to the second structure 500. Accordingly, lifting of the first substrate 100 and/or the second substrate 400 by pressure generated by the filling member 700 may be reduced.

Additionally, due to the first structure 300 and the second structure 500, it is possible to reduce penetration of external moisture and/or foreign substances into the sealing member 600. Accordingly, the durability of the display device 1 may be improved.

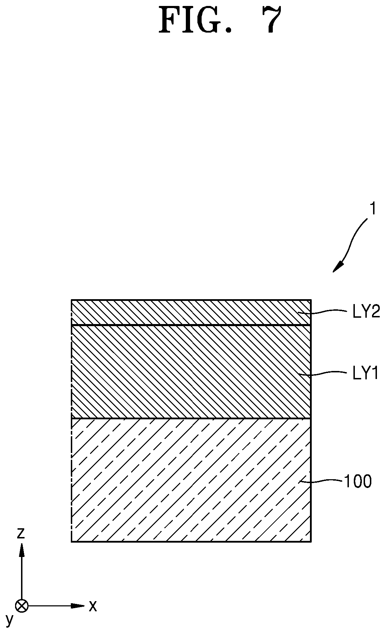

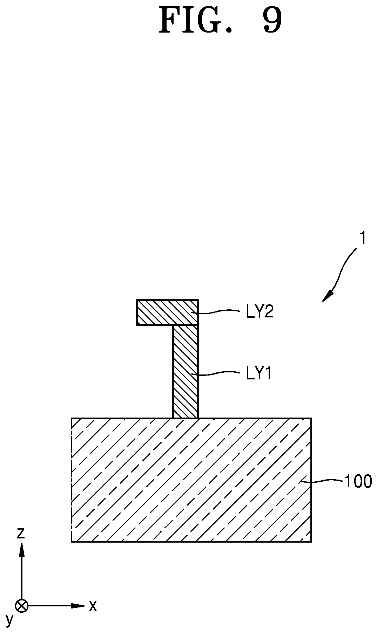

FIGS. 7 to 9 are cross-sectional views schematically illustrating an embodiment of a portion of the display device 1.

Referring to FIGS 7 to 9, the first structure 300 may be formed on the first substrate 100.

Referring to FIG. 7, a first layer LY1 may be disposed on the first substrate 100, and a second layer LY2 may be disposed on the first layer LY1.

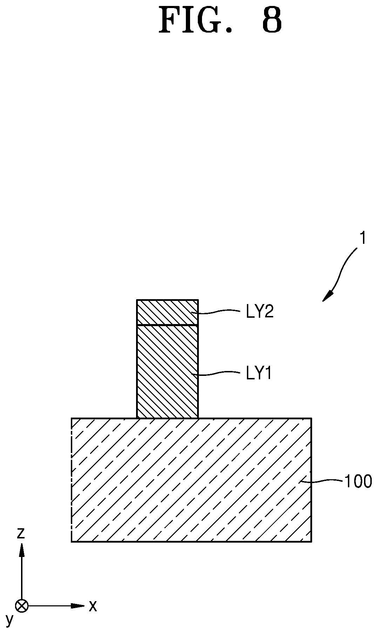

Referring to FIGS. 7 and 8, portions of the first layer LY1 and the second layer LY2 may be etched through a photolithography process. A photoresist pattern may be formed on the first layer LY1 and the second layer LY2, excluding the portion of the first layer LY1 and the second layer LY2 to be etched. Next, portions of the first layer LY1 and the second layer LY2 may be etched on top of the second layer LY2 using an etching process. The etching process may be performed by wet etching, dry etching, or a combination thereof. Next, the photoresist pattern is removed. Known methods may be used to remove the photoresist pattern.

Referring to FIGS. 7 and 8, a portion of the first layer LY1 may be etched using an etching process. The first layer LY1 and the second layer LY2 may have different etch selectivity. The etch selectivity of the first layer LY1 may be greater than that of the second layer LY2. The etching process may be performed by wet etching, dry etching, or a combination thereof. In this process, the first structure 300 may include the first-1 structure 310 and the first-2 structure 320 shown in FIG. 3.

The second structure 500 shown in FIG. 3 may be formed on the second substrate 400 by a same process as the process described with reference to FIGS. 7 to 9. Because this process was described above with reference to FIGS. 7 to 9, detailed description will be omitted.

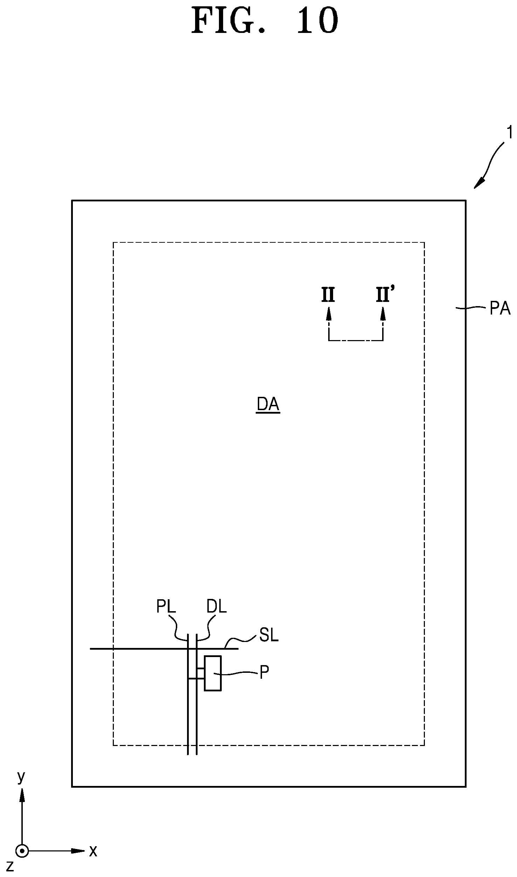

FIG. 10 is a plan view schematically illustrating an embodiment of the display device 1.

In FIG. 10, the same reference numerals as in FIG. 1 refer to the same members, and their duplicate descriptions will be omitted.

Referring to FIG. 10, the display device 1 may provide a predetermined image by light emitted from a plurality of pixels P in the display area DA.

Each of the plurality of pixels P may include a display element such as an organic light-emitting diode or an inorganic light-emitting diode, and may emit red light, green light, blue light, or white light, for example. That is, each of the plurality of pixels P may be connected to a pixel circuit including a thin-film transistor, a storage capacitor, or the like. The pixel circuit may be connected to a scan line SL, and a data line DL and a driving voltage line PL crossing the scan line SL. The scan line SL may extend in an x direction, and the data line DL and the driving voltage line PL may extend in a y direction.

Due to driving of the pixel circuit, the pixels P may emit light. The display area DA may provide a predetermined image according to light emitted from the plurality of pixels P. As described above, each of the plurality of pixels P in this specification may be defined as an emission area which emits red light, green light, blue light, or white light.

The peripheral area PA is an area in which the plurality of pixels P are not arranged and no image is provided. An internal driving circuit, a power supply line, and a printed circuit board including a driving circuit, and/or a terminal portion connected to driver integrated circuit may be in the peripheral area PA so as to drive the plurality of pixels P.

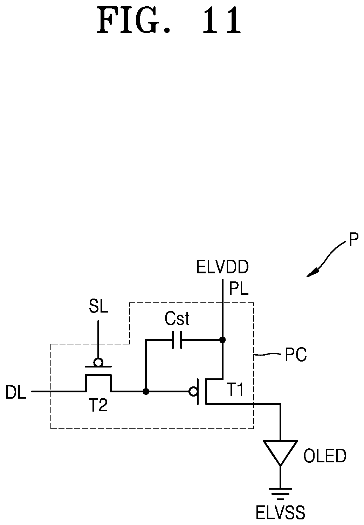

FIG. 11 illustrates an embodiment of a display element and a pixel circuit PC connected thereto in a pixel P of the display device (refer to 1 of FIG.10).

Referring to FIG. 11, the display element, i.e., an organic light-emitting diode OLED, is connected to the pixel circuit PC. The pixel circuit PC may include a first thin-film transistor T1, a second thin-film transistor T2, and a storage capacitor Cst. In an embodiment, the organic light-emitting diode OLED may emit red light, green light, or blue light, or may emit red light, green light, blue light, or white light, for example.

The second thin-film transistor T2 is a switching thin-film transistor. The second thin-film transistor T2 may be connected to a scan line SL and a data line DL, and may transmit, to the first thin-film transistor T1, a data voltage input from the data line DL according to a switching voltage input from the scan line SL. The storage capacitor Cst may be connected to the second thin-film transistor T2 and a driving voltage line PL, and may store charges corresponding to a difference between a voltage received from the second thin-film transistor T2 and a first power supply voltage ELVDD supplied to the driving voltage line PL.

The first thin-film transistor T1 may be a driving thin-film transistor. The first thin-film transistor T1 may be connected to the driving voltage line PL and the storage capacitor Cst, and may control a driving current flowing from the driving voltage line PL to the organic light-emitting diode OLED in response to charges stored in the storage capacitor Cst. The organic light-emitting diode OLED may emit light having a predetermined luminance according to the driving current. An opposite electrode (e.g., a cathode) of the organic light-emitting diode OLED may receive a second power supply voltage ELVSS.

FIG. 11 illustrates that the pixel circuit PC includes two thin-film transistors and one storage capacitor, but in another embodiment, the number of thin-film transistors or the number of storage capacitors may be variously changed according to the design of the pixel circuit PC.

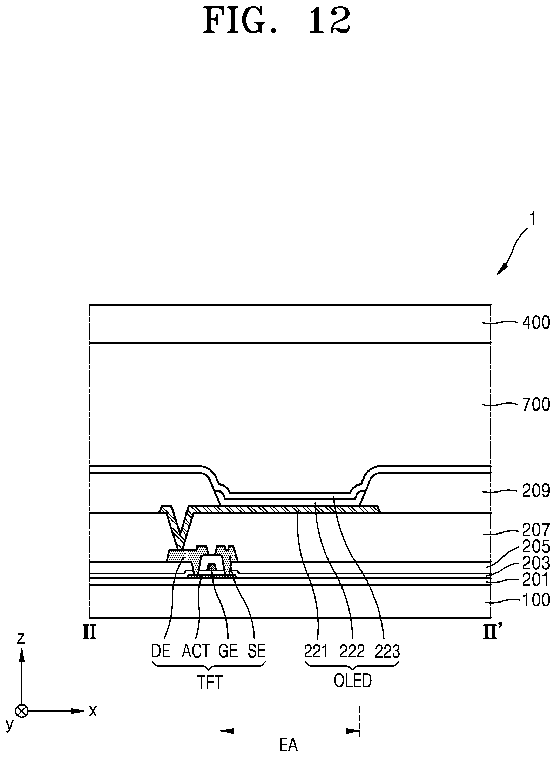

FIG. 12 is a cross-sectional view schematically illustrating an embodiment of a portion of the display device 1.

Specifically, FIG. 12 is a cross-sectional view taken along line II-II' of FIG. 10.

In FIG. 12, the same reference numerals as in FIG. 2 refer to the same members, and their duplicate descriptions will be omitted.

Referring to FIG. 12, the display device 1 includes a first substrate 100, an organic light-emitting diode OLED as a display element including a light-emitting area EA on the first substrate 100, and a second substrate 400 that seals the display element. When the same reference numerals (1, 100, 400, etc.) are used, then each of these elements should be described using "the," for example, the display device 1 and so on. When these elements are different elements according to other embodiments, but correspond to the previously described elements, they should be denoted using different reference numerals, e.g., 1a or 1', 100a, 100', etc., and should be introduced using "a" and then referred back to them using "the." The same issue appears with regard to the descriptions for other previous drawings.

A thin-film transistor TFT may include a semiconductor layer ACT, a gate electrode GE, a source electrode SE, and a drain electrode DE. The semiconductor layer ACT may include amorphous silicon, polycrystalline silicon, or an organic semiconductor material. In order to secure insulation between the semiconductor layer ACT and the gate electrode GE, a gate insulating layer 203 including an inorganic material such as silicon oxide, silicon nitride, and/or silicon oxynitride may be between the semiconductor layer ACT and the gate electrode GE. Also, an inter-insulating layer 205 including an inorganic material such as silicon oxide, silicon nitride, and/or silicon oxynitride may be on the gate electrode GE, and the source electrode SE and the drain electrode DE may be on the inter-insulating layer 205. The insulating layer including the inorganic material may be formed through chemical vapor deposition ("CVD") or atomic layer deposition ("ALD").

The gate electrode GE, the source electrode SE, and the drain electrode DE may include various conductive materials. The gate electrode GE may include at least one of molybdenum, aluminium, copper, and titanium, and may have a multilayer structure. In an embodiment, the gate electrode GE may have a single molybdenum layer, or may have a three-layer structure including a molybdenum layer, an aluminium layer, and a molybdenum layer, for example. The source electrode SE and the drain electrode DE may include at least one of copper, titanium, and aluminium, and may have a multilayer structure. In an embodiment, the source electrode SE and the drain electrode DE may have a three-layer structure including a titanium layer, an aluminium layer, and a titanium layer, for example.

A buffer layer 201 including an inorganic material such as silicon oxide, silicon nitride, and/or silicon oxynitride may be between the thin-film transistor TFT and the first substrate 100. The buffer layer 201 may increase smoothness of the upper surface of the first substrate 100, or may prevent or minimize infiltration of impurities from the first substrate 100 or the like into the semiconductor layer ACT of the thin-film transistor TFT.

A planarization insulating layer 207 may be disposed on the thin-film transistor TFT. The planarization insulating layer 207 may include, e.g., an organic material such as acryl, benzocyclobutene ("BCB"), or hexamethyldisiloxane ("HMDSO"). In FIG. 12, the planarization insulating layer 207 is illustrated as a single layer, but may include multiple layers.

The pixel electrode 221 may be on the planarization insulating layer 207. The pixel electrode 221 is disposed for each of the plurality of pixels P. The pixel electrodes 221 corresponding to neighboring pixels may be spaced apart from each other.

The pixel electrode 221 may be a reflective electrode. In some embodiments, the pixel electrode 221 may include a reflective layer including Ag, Mg, Al, Pt, Pd, Au, Ni, Nd, Ir, Cr, and any combination thereof, and a transparent or semitransparent electrode layer on the reflective layer. The transparent or semitransparent electrode layer may include at least one selected from indium tin oxide ("ITO"), indium zinc oxide ("IZO"), zinc oxide (ZnO), indium oxide (In₂O₃), indium gallium oxide ("IGO"), and aluminium zinc oxide ("AZO"). In some embodiments, the pixel electrode 221 may have a three-layer structure including an ITO layer, an Ag layer, and an ITO layer.

A pixel defining layer 209 is on the pixel electrode 221. The pixel defining layer 209 defines an opening exposing the central portion of the pixel electrode 221. The pixel defining layer 209 may prevent an electric arc or the like from occurring on edges of the pixel electrode 221 by covering the edges of the pixel electrode 221 and increasing distances between the edges of the pixel electrode 221 and portions of an opposite electrode 223. The pixel defining layer 209 may include an organic insulating material such as polyimide, polyamide, acrylic resin, benzocyclobutene, HMDSO, and phenolic resin, and may be formed by spin coating or the like. In an alternative embodiment, the pixel defining layer 209 may include an inorganic insulating material. In an alternative embodiment, the pixel defining layer 209 may have a multilayer structure including an inorganic insulating material and an organic insulating material.

In some embodiments, the pixel defining layer 209 may include a light-blocking material and may be black. The light-blocking material may include carbon black, carbon nanotubes, a resin or paste including black dye, metal particles (e.g., nickel, aluminium, molybdenum, and any alloy thereof), metal oxide particles (e.g., chromium oxide), or metal nitride particles (e.g., chromium nitride). When the pixel defining layer 209 includes a light-blocking material, reflection of external light due to metal structures under the pixel defining layer 209 may be reduced.

An emission layer 222 may be inside an opening in the pixel defining layer 209. The emission layer 222 may be an organic material including a fluorescent or phosphorescent material capable of emitting red light, green light, or red light. The organic material may include a relatively low molecular weight organic material or a relatively high molecular weight organic material.

A first common layer (not illustrated) and a second common layer (not illustrated) may be below and above the emission layer 222, respectively. When the first common layer is below the emission layer 222, the first common layer may include a hole transport layer or may include a hole transport layer and a hole injection layer, for example. When the second common layer is above the emission layer 222, the second common layer may include an electron transport layer and/or an electron injection layer. In some embodiments, the second common layer may be omitted.

The emission layer 222 is disposed for each of the plurality of pixels P to correspond to the opening in the pixel defining layer 209, and the first common layer and the second common layer may be provided as one body to cover an entirety of the first substrate 100, e.g., to cover an entirety of the display area of the first substrate 100, as the opposite electrode 223 to be described below.

The opposite electrode 223 may be a cathode that is an electron injection electrode. In this case, the opposite electrode 223 may include a metal, an alloy, an electrically conductive compound, or any combination thereof, which has a relatively low work function. The opposite electrode 223 may be a transmissive electrode, a transflective electrode, or a reflective electrode.

The opposite electrode 223 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The opposite electrode 223 may have a single-layer structure or a multilayer structure including a plurality of layers.

A capping layer (not illustrated) may be further on the opposite electrode 223. The capping layer may improve an external luminescence efficiency of the organic light-emitting element due to the principle of constructive interference. The capping layer may include a material having a refractive index of about 1.6 or more (at a wavelength of about 589 nanometers (nm)). The capping layer may have a thickness of about 1 nm to about 200 nm, e.g., about 5 nm to about 150 nm, or about 10 nm to about 100 nm. The capping layer may be an organic capping layer including an organic material, an inorganic capping layer including an inorganic material, or a composite capping layer including an organic material and an inorganic material.

The second substrate 400 may face the first substrate 100 and may be on the organic light-emitting diode OLED that is the display element.

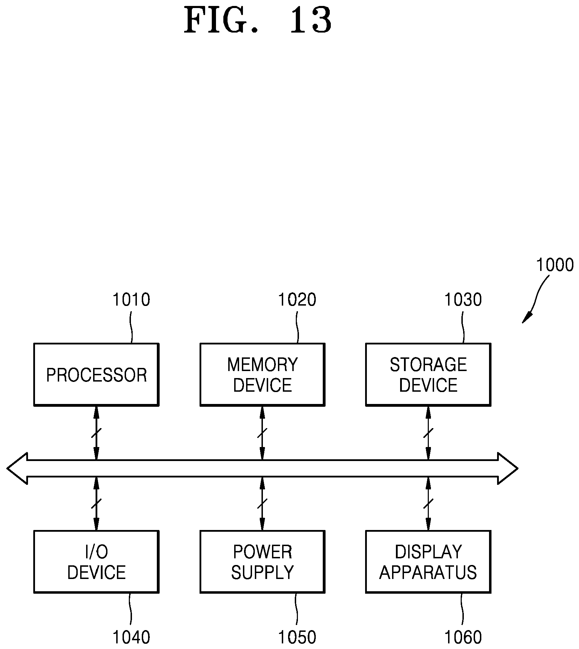

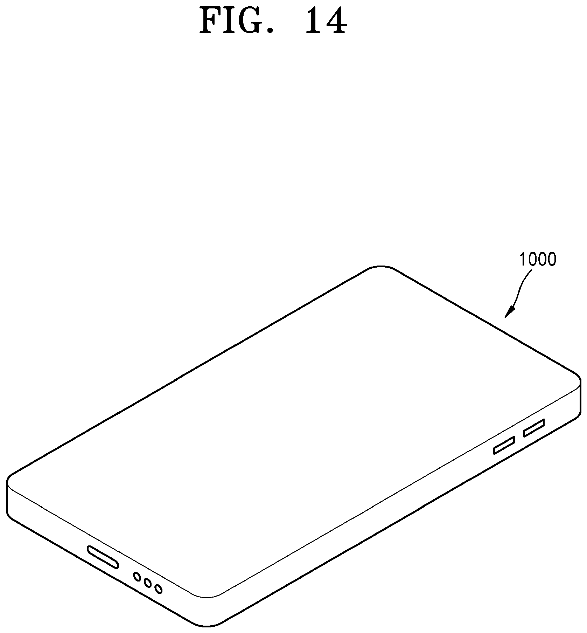

FIG. 13 is a block diagram illustrating an electronic device according to an embodiment. FIG. 14 is a view illustrating an embodiment of the electronic device of FIG. 13 implemented as a smartphone.

Referring to FIGS. 13 and 14, in an embodiment, an electronic device 1000 may include a processor 1010, a memory device 1020, a storage device 1030, an input/output ("I/O") device 1040, a power supply 1050, and a display device 1060. Here, the display device 1060 may correspond to the display device 1 of FIG. 1. The electronic device 1000 may further include a plurality of ports for communicating with a video card, a sound card, a memory card, a universal serial bus ("USB") device, or the like. In an embodiment, the electronic device 1000 may be implemented as a television. In another embodiment, the electronic device 1000 may be implemented as a smart phone. However, embodiments are not limited thereto, in another embodiment, the electronic device 1000 may be implemented as a cellular phone, a video phone, a smart pad, a smart watch, a tablet personal computer, a car navigation system, a computer monitor, a laptop, a head disposed (e.g., mounted) display ("HMD"), or the like.

The processor 1010 may perform various computing functions. In an embodiment, the processor 1010 may be a microprocessor, a central processing unit ("CPU"), an application processor ("AP"), or the like. The processor 1010 may be coupled to other components via an address bus, a control bus, a data bus, or the like. In an embodiment, the processor 1010 may be coupled to an extended bus such as a peripheral component interconnection ("PCI") bus.

The memory device 1020 may store data for operations of the electronic device 1000. In an embodiment, the memory device 1020 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like, and/or at least one volatile memory device such as a dynamic random access memory ("DRAM") device, a static random access memory ("SRAM") device, a mobile DRAM device, or the like.

In an embodiment, the storage device 1030 may include a solid state drive ("SSD") device, a hard disk drive ("HDD") device, a CD-ROM device, or the like. In an embodiment, the I/O device 1040 may include an input device such as a keyboard, a keypad, a mouse device, a touchpad, a touch-screen, or the like, and an output device such as a printer, a speaker, or the like.

The power supply 1050 may provide power for operations of the electronic device 1000. The power supply 1050 may provide power to the display device 1060. The display device 1060 may be coupled to other components via the buses or other communication links. In an embodiment, the display device 1060 may be included in the I/O device 1040.

In an embodiment the electronic device may be implemented as a smartphone. However the embodiments of the present disclosure may be exemplary and may not be limited to this. For example, the electronic device 1000 may be implemented as a mobile phone, a video phone, a smart pad, a smart watch, a television, a tablet personal computer, a vehicle display, a computer monitor, a notebook computer, a head-mounted display device, etc. In addition, the electronic device 1000 may be a television, a monitor, a notebook computer, or a tablet. In addition, the electronic device 1000 may be a car.

By embodiments, durability of the display device 1 may be improved.

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the scope as defined by the following claims.

## Claims

1. A display device (1) in which a display area (DA) and a peripheral area (PA) are defined, the display device (1) comprising:
a first substrate (100) including a first surface (100S);
a display layer (200) disposed on the first surface (100S) of the first substrate (100), the display layer (200) including:
a pixel circuit layer (PCL); and
a display element layer (DPL) disposed on the pixel circuit layer (PCL);
a second substrate (400) including a second surface (400S) opposite the first surface (100S), disposed on the first substrate (100) and spaced apart from the display layer (200);
a sealing member (600) supporting the second substrate (400) from the first substrate (100) in the peripheral area (PA);
a filling member (700) filled between the first substrate (100) and the second substrate (400);
a first structure (300) fixed to the first surface (100S) in the peripheral area (PA); and
a second structure (500) fixed to the second surface (400S) in the peripheral area (PA) and in contact with the first structure (300).

2. The display device (1) of claim 1, wherein
the first structure (300) comprises:
a first-1 structure (310) extending from the first surface (100S) in a first-1 direction to the second surface (400S), and
a first-2 structure (320) extending from the first-1 structure (310) in a second-1 direction intersecting the first-1 direction, and
the second structure (500) comprises:
a second-1 structure (510) extending from the second surface (400S) in a first-2 direction opposite to the first-1 direction, and
a second-2 structure (520) extending from the second-1 structure (510) in a second-2 direction opposite to the second-1 direction.

3. The display device (1) of claim 2, wherein
the first-2 structure (320) and the second-2 structure (520) contact each other.

4. The display device (1) of claim 2 or claim 3, wherein
in a cross-section of the first substrate (100), the first structure (300) and the second structure (500) each have an 'L' shape.

5. The display device (1) of any one of claims 2 to 4, wherein
the first-2 structure (320) is closer to the second substrate (400) than the second-2 structure (520) is to the second substrate (400).

6. The display device (1) of any one of claims 2 to 5, wherein
the second-2 structure (520) is closer to the first substrate (100) than the first-2 structure (320) is to the first substrate (100).

7. The display device (1) of any one of claims 2 to 6, wherein
the second-1 structure (510) is closer to the display layer (200) than the first-1 structure (310) is closer to the display layer (200).

8. The display device (1) of any one of claims 1 to 7, wherein
the first structure (300) and the second structure (500) are in surface contact with each other.

9. The display device (1) of any one of claims 1 to 7, wherein
at least one of the first structure (300) and the second structure (500) is sealed by the sealing member (600).

10. The display device (1) of any one of claims 1 to 9, wherein
at least one of the first structure (300) and the second structure (500) includes an inorganic material.

11. An electronic device (1000) comprising:
a display device (1) in which a display area (DA) and a peripheral area (PA) are defined, the display device (1) comprising:
a first part (PT1) comprising:
a first substrate (100);
a display layer (200) disposed on the first substrate (100); and
a first structure (300) fixed to the first substrate (100) in the peripheral area (PA);
a second part (PT2) disposed on the first part (PT1), the second part (PT2) comprising:
a second substrate (400); and
a second structure (500) fixed to the second substrate (400) in the peripheral area (PA);
a sealing member (600) supporting the second part (PT2) from the first part (PT1) in the peripheral area (PA); and
a filling member (700) filled between the first part (PT1) and the second part (PT2),
wherein the first structure (300) and the second structure (500) are fastened to each other.

12. The electronic device (1000) of claim 11, wherein:
(i) the first structure (300) and the second structure (500) are in surface contact with each other; and/or
(ii) in a cross-section of the first substrate (100), the first structure (300) and the second structure (500) each have an 'L' shape.

13. The electronic device (1000) of claim 11 or claim 12, wherein:
(i) at least one of the first structure (300) and the second structure (500) is sealed by the sealing member (600); and/or
(ii) at least one of the first structure (300) and the second structure (500) includes an inorganic material.

14. The electronic device (1000) of any one of claims 11 to 13, wherein the first structure (300) comprises:
a first-1 structure (310) extending from the first substrate (100) in a first-1 direction to the second substrate (400), and
a first-2 structure (320) extending from the first-1 structure (310) in a second-1 direction intersecting the first-1 direction, and
the second structure (500) comprises:
a second-1 structure (510) extending from the second substrate (400) in a first-2 direction opposite to the first-1 direction, and
a second-2 structure (520) extending from the second-1 structure (510) in a second-2 direction opposite to the second-1 direction.

15. The electronic device (1000) of claim 14, wherein:
(i) the first-2 structure (320) and the second-2 structure (520) contact each other; and/or
(ii) the first-2 structure (320) is closer to the second substrate (400) than the second-2 structure (520) is to the second substrate (400); and/or
(iii) the second-2 structure (520) is closer to the first substrate (100) than the first-2 structure (320) is to the first substrate (100); and/or
(iv) the second-1 structure (510) is closer to the display layer (200) than the first-1 structure (310) is to the display layer (200).
